# EUROPEAN PATENT APPLICATION

(11) **EP 4 365 968 A1**
(43) Date of publication of application: **08.05.2024**
(21) Application number: 22832781.3
(22) Date of filing: 13.06.2022
(51) Int. Cl.: H01L 33/32, H01S 5/02335, H01S 5/042, H01S 5/343

(54) **LIGHT-EMITTING BODY, METHOD AND APPARATUS FOR PRODUCING LIGHT-EMITTING BODY, LIGHT-EMITTING ELEMENT AND METHOD FOR PRODUCING SAME, AND ELECTRONIC DEVICE**

(30) Priority: 30.06.2021 JP 2021109524
(71) Applicant: Kyocera Corporation, Kyoto-shi Kyoto 612-8501 (JP)
(72) Inventor: KAWAGUCHI, Yoshinobu, Kyoto-shi, Kyoto 612-8501 (JP); KAMIKAWA, Takeshi, Kyoto-shi, Kyoto 612-8501 (JP); MURAKAWA, Kentaro, Kyoto-shi, Kyoto 612-8501 (JP)
(74) Representative: Viering, Jentschura & Partner mbB Patent- und Rechtsanwälte
(86) International application number: PCT/JP2022/023564
(87) International publication number: WO 2023/276624

(57) **Abstract**

A light-emitting body includes a base semiconductor part including a nitride semiconductor, a compound semiconductor part including a nitride semiconductor and positioned above the base semiconductor part, and a first electrode and a second electrode. The base semiconductor part includes first part and second part having a density of threading dislocation extending in a thickness direction lower than that of the first part, at least part of the first electrode and at least part of the second electrode are positioned on the compound semiconductor part, and at least part of the first electrode is positioned above the second part.

## Description

### TECHNICAL FIELD

The present disclosure relates to a light-emitting body.

### BACKGROUND OF INVENTION

In a nitride semiconductor laser described in Patent Document 1, an anode and a cathode are formed on one surface of a chip including a semiconductor layer. When a current path from the anode to the cathode includes a portion oriented parallel to a c-plane of the semiconductor layer, the light emission efficiency decreases.

### CITATION LIST

### PATENT LITERATURE

Patent Document 1: JP 2000-49415 A

### SUMMARY

In the present disclosure, a light-emitting body includes a base semiconductor part including a nitride semiconductor, a compound semiconductor part including a nitride semiconductor and positioned above the base semiconductor part, and a first electrode and a second electrode. The base semiconductor part includes first part and second part having a density of threading dislocation extending in a thickness direction lower than that of the first part, at least part of the first electrode and at least part of the second electrode are positioned on the compound semiconductor part, and at least part of the first electrode is positioned above the second part.

### BRIEF DESCRIPTION OF THE DRAWINGS

FIG. 1 is a perspective view illustrating a configuration of a light-emitting body according to the present embodiment.
FIG. 2 is a schematic view illustrating a configuration of a light-emitting device according to the present embodiment.
FIG. 3 is a flowchart illustrating an example of a method for manufacturing the light-emitting body according to the present embodiment.
FIG. 4 is a block diagram illustrating an example of an apparatus for manufacturing the light-emitting body according to the present embodiment.
FIG. 5 is a perspective view illustrating a configuration of a light-emitting body according to Example 1.
FIG. 6 is a plan view illustrating a configuration of a compound semiconductor part.
FIG. 7 is a cross-sectional view illustrating the configuration of the light-emitting body according to Example 1.
FIG. 8 is a cross-sectional view illustrating another configuration of the light-emitting body according to Example 1.
FIG. 9 is a cross-sectional view illustrating another configuration of the light-emitting body according to Example 1.
FIG. 10 is a cross-sectional view illustrating another configuration of the light-emitting body according to Example 1.
FIG. 11 is a cross-sectional view illustrating another configuration of the light-emitting body according to Example 1.
FIG. 12 is a cross-sectional view illustrating another configuration of the light-emitting body according to Example 1.
FIG. 13 is a cross-sectional view illustrating another configuration of the light-emitting body according to Example 1.
FIG. 14 is a cross-sectional view illustrating another configuration of the light-emitting body according to Example 1.
FIG. 15 is a cross-sectional view illustrating another configuration of the light-emitting body according to Example 1.
FIG. 16 is a perspective view illustrating another configuration of the light-emitting body according to Example 1.
FIG. 17 is a top view and a cross-sectional view of FIG. 16.
FIG. 18 is a perspective view illustrating another configuration of the light-emitting body according to Example 1.
FIG. 19 is a top view and a cross-sectional view of FIG. 18.
FIG. 20 is a cross-sectional view illustrating a configuration of a light-emitting element according to Example 1.
FIG. 21 is a perspective view illustrating a configuration of the light-emitting element according to Example 1.
FIG. 22 is a cross-sectional view illustrating another configuration of the light-emitting element according to Example 1.
FIG. 23 is a cross-sectional view illustrating another configuration of the light-emitting element according to Example 1.
FIG. 24 is a cross-sectional view illustrating another configuration of the light-emitting element according to Example 1.
FIG. 25 is a perspective view illustrating a configuration of a light-emitting substrate (semiconductor laser array) according to Example 1.
FIG. 26 is a perspective view illustrating another configuration of the light-emitting substrate according to Example 1.
FIG. 27 is a flowchart illustrating an example of a method for manufacturing a light-emitting device according to Example 1.
FIG. 28 is schematic cross-sectional views illustrating the method for manufacturing the light-emitting device in FIG. 27.
FIG. 29 is plan views illustrating the method for manufacturing the light-emitting device in
FIG. 27.

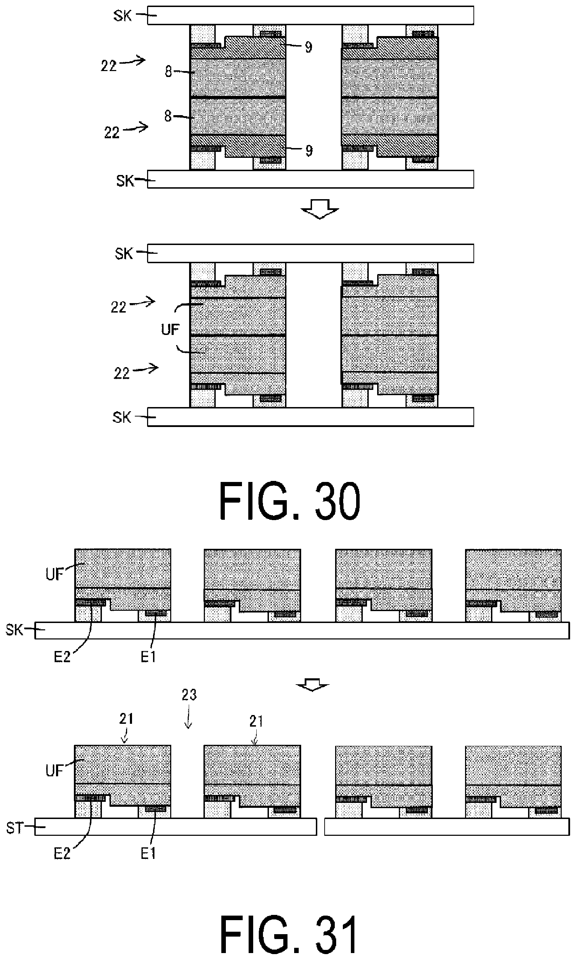

FIG. 30 is schematic cross-sectional views illustrating another example of the method for manufacturing the light-emitting device according to Example 1.
FIG. 31 is schematic cross-sectional views illustrating another example of the method for manufacturing the light-emitting device according to Example 1.

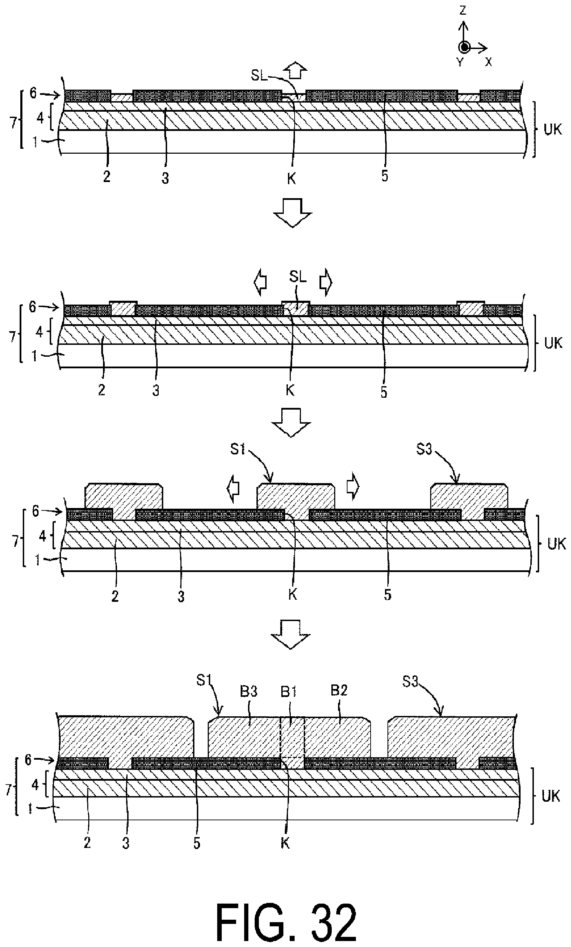

FIG. 32 is cross-sectional views illustrating an example of growth of a base semiconductor part (ELO semiconductor layer) in a lateral direction in Example 1.

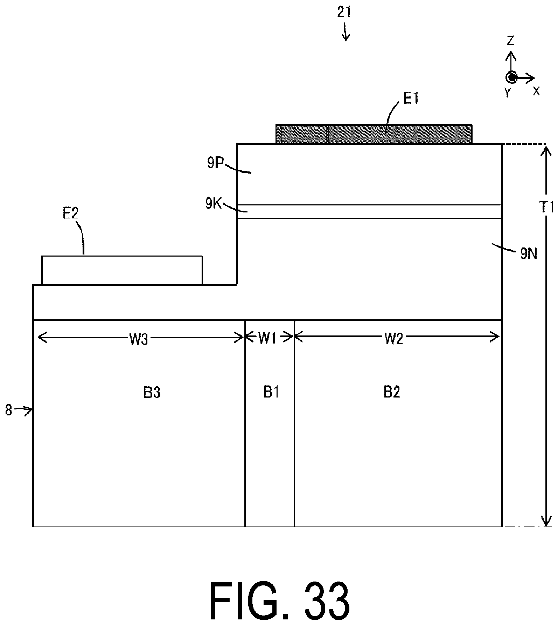

FIG. 33 is a cross-sectional view illustrating a configuration of a light-emitting body according to Example 2.

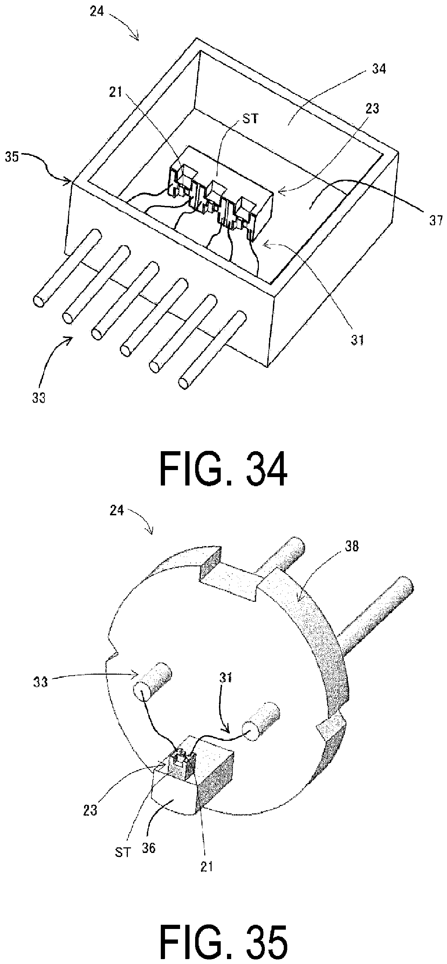

FIG. 34 is a perspective view illustrating a configuration of a light-emitting module according to Example 4.
FIG. 35 is a perspective view illustrating another configuration of the light-emitting module according to Example 4.

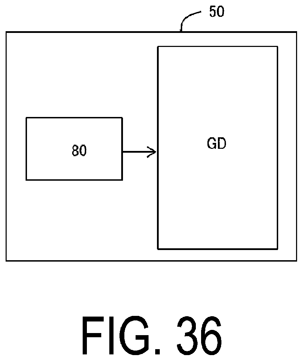

FIG. 36 is a schematic view illustrating a configuration of an electronic device according to Example 5.

### DESCRIPTION OF EMBODIMENTS

### Light-Emitting Body

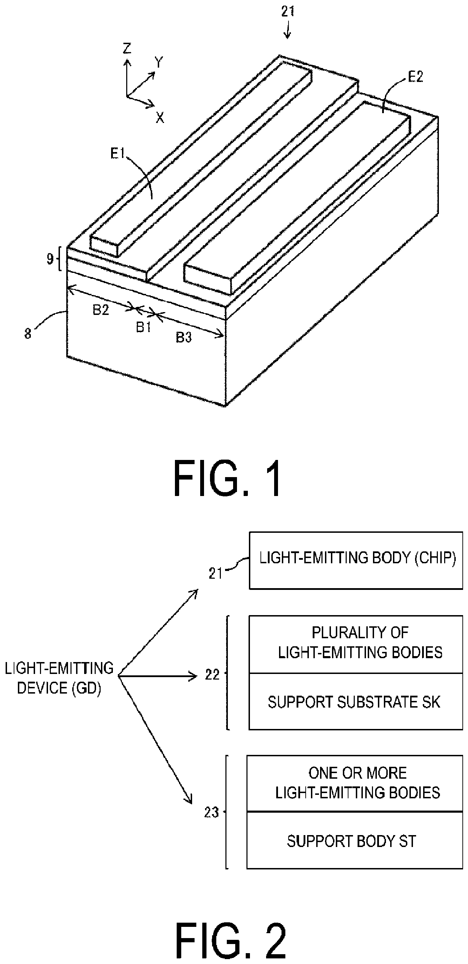

FIG. 1 is a perspective view illustrating a configuration of a light-emitting body according to the present embodiment. As illustrated in FIG. 1, a light-emitting body 21 according to the present embodiment includes a base semiconductor part 8 including a nitride semiconductor, a compound semiconductor part 9 including a nitride semiconductor and positioned above the base semiconductor part 8, and a first electrode E1 and a second electrode E2. The base semiconductor part 8 includes first part B1, and second part B2 having a lower density of threading dislocation extending in a thickness direction (Z direction) than that of the first part B1. At least part of the first electrode E1 and at least part of the second electrode E2 are positioned on the compound semiconductor part 9. At least part of the first electrode E1 may be positioned above the second part B2. Hereinafter, a direction from the base semiconductor part 8 to the compound semiconductor part 9 is referred to as an upward direction. In the light-emitting body 21, the base semiconductor part 8 may be a base semiconductor layer 8, and the compound semiconductor part 9 may be a compound semiconductor layer 9. The light-emitting body 21 may be a light-emitting diode (LED) chip or a semiconductor laser chip.

The base semiconductor part 8 of the light-emitting body 21 includes the second part B2 (low-defect part) having a low density of threading dislocation, which can improve the light emission efficiency and reliability in the configuration in which the first and second electrodes E1 and E2 are provided on one surface of a chip. This is because the threading dislocation causes heat generation.

In the present embodiment, the second part B2 of the base semiconductor part 8 and the first electrode E1 may overlap each other in plan view. "Two members overlap each other" means that at least part of one member overlaps the other member in plan view (including a perspective plan view) viewed in a thickness direction of each member, and these members may or do not need to be in contact with each other.

The nitride semiconductor included in each of the base semiconductor part 8 and the compound semiconductor part 9 can be expressed, for example, as AlxGayInzN (0 ≤ x ≤ 1; 0 ≤ y ≤ 1; 0 ≤ z ≤ 1; x + y + z = 1). Specific examples of the nitride semiconductor can include a GaN-based semiconductor, aluminum nitride (AlN), indium aluminum nitride (InAlN), and indium nitride (InN). The GaN-based semiconductor is a semiconductor containing a gallium atom (Ga) and a nitrogen atom (N). Typical examples of the GaN-based semiconductor can include GaN, AlGaN, AlGaInN, and InGaN. The base semiconductor part 8 may be of a doped type (for example, an n-type including a donor) or a non-doped type.

The base semiconductor part 8 including a nitride semiconductor can be formed by an epitaxial lateral overgrowth (ELO) method. In the ELO method, for example, the base semiconductor part 8 is laterally grown on a template substrate including a mask pattern (mask for selective growth) including an opening part and a mask part (which will be described later). This can form low-defect part (the second part B2) having a low density of threading dislocation on the mask part. The number of threading dislocations (dislocations extending in the thickness direction) taken over by the compound semiconductor part 9 (for example, the GaN-based semiconductor layer) on the second part B2 is reduced, causing the light emission efficiency to be increased.

### Light-Emitting Device

FIG. 2 is a schematic view illustrating a configuration of a light-emitting device according to the present embodiment. A light-emitting substrate 22 according to the present embodiment includes a plurality of light-emitting bodies 21 (chips) and a support substrate SK on which the plurality of light-emitting bodies 21 are mounted. A light-emitting element 23 according to the present embodiment includes one or more light-emitting bodies 21 and a support body ST placed with the one or more light-emitting bodies 21. Hereinafter, the light-emitting body 21, the light-emitting substrate 22, the light-emitting element 23, and a light-emitting module, which will be described below, may be collectively referred to as a light-emitting device.

### Manufacturing Light-Emitting Body

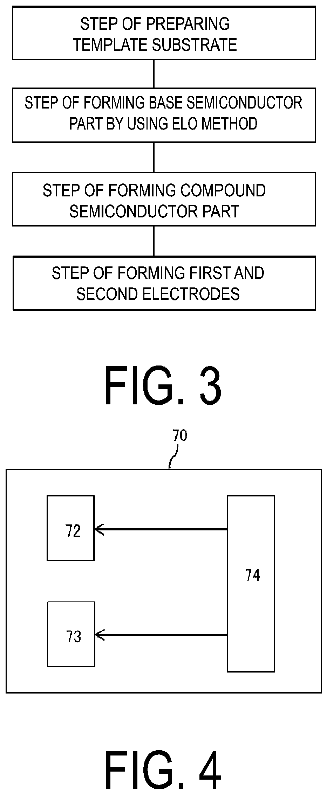

FIG. 3 is a flowchart illustrating an example of a method for manufacturing the light-emitting body according to the present embodiment. In the method for manufacturing in FIG. 3, after a step of preparing a template substrate (substrate for ELO growth), a step of forming the base semiconductor part 8 by using an ELO method, a step of forming the compound semiconductor part 9, and a step of forming the first and second electrodes E1 and E2 are performed.

FIG. 4 is a block diagram illustrating an example of an apparatus for manufacturing the light-emitting body according to the present embodiment. The apparatus 70 for manufacturing the light-emitting body in FIG. 4 includes a semiconductor former 72 configured to form the base semiconductor part 8 and the compound semiconductor part 9 on the template substrate, an electrode former 73 configured to form the first and second electrodes E1 and E2, and a controller 74 configured to control the semiconductor former 72 and the electrode former 73.

The semiconductor former 72 may include a metal organic chemical vapor deposition (MOCVD) device, and the controller 74 may include a processor and a memory. The controller 74 may be configured to control the semiconductor former 72 and the electrode former 73 by, for example, executing a program stored in a built-in memory, or a communicable communication device, or on an accessible network. The program, a recording medium storing the program, and the like are also included in the present embodiment.

### Example 1

### Configuration

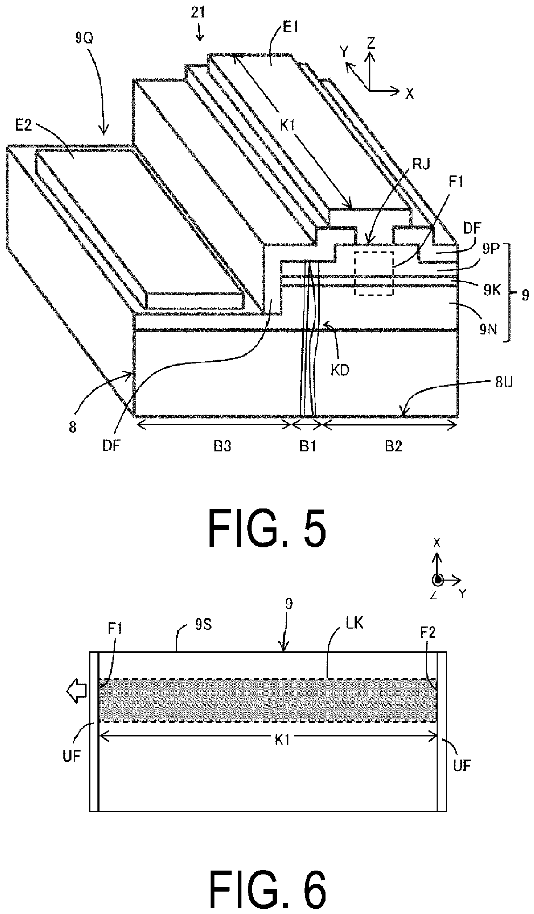

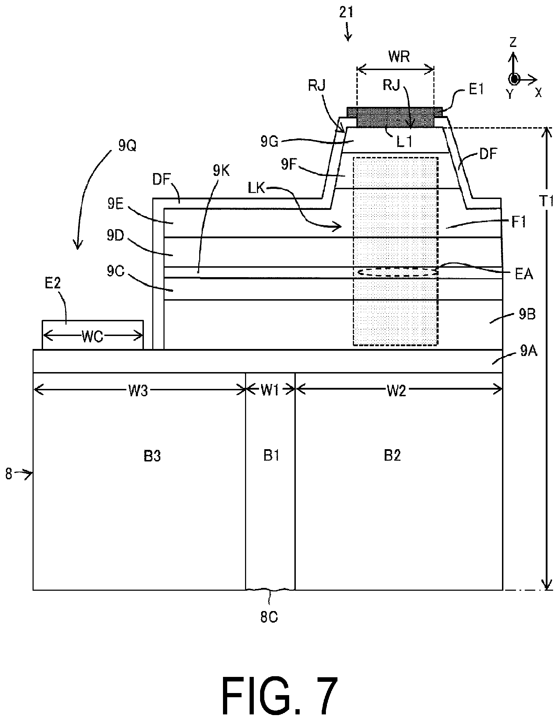

FIG. 5 is a perspective view illustrating a configuration of a light-emitting body according to Example 1. FIG. 6 is a plan view illustrating a configuration of a compound semiconductor part. FIG. 7 is a cross-sectional view illustrating a configuration of the light-emitting body according to Example 1. As illustrated in FIG. 5 to FIG. 7, the light-emitting body 21 according to Example 1 includes the base semiconductor part 8, the compound semiconductor part 9 positioned on the base semiconductor part 8, the first electrode E1 serving as an anode, and the second electrode E2 as a cathode. The light-emitting body 21 can also be referred to as a semiconductor laser chip.

The base semiconductor part 8 and the compound semiconductor part 9 are nitride semiconductor layers (for example, GaN-based semiconductor layers), and the base semiconductor part 8 is an n-type semiconductor layer containing a donor. FIG. 5 and the like refers to an <11-20> direction of the base semiconductor part 8 as an X direction, a <1-100> direction as a Y direction, and a <0001> direction as a Z direction (thickness direction).

The base semiconductor part 8 is a free-standing layer not including a support member, and an upper surface of the base semiconductor part 8 is in contact with the compound semiconductor part 9, and a lower surface 8U of the base semiconductor part 8 is exposed (although the lower surface 8U is exposed on a chip basis, a case may occur where the lower surface 8U is not exposed after mounting).

The base semiconductor part 8 includes the first part B1 including a threading dislocation KD extending in the Z direction, and the second part B2 and third part B3 each of which has a density of threading dislocation smaller than that of the first part B 1. The second part B2, the first part B1, and the third part B3 are disposed in this order in the X direction, and the first part B1 is positioned between the second part B2 and the third part B3. The first part B1 is a portion positioned on an opening part of a mask layer 6 when the base semiconductor part 8 is formed by the ELO method, which will be described later. The density of threading dislocation of each of the second part B2 and the third part B3 is equal to or less than 1/5 the density of threading dislocation of the first part B1 (for example, equal to or less than 5 × 10⁶/cm²).

The compound semiconductor part 9 is formed with a first type (n-type) semiconductor layer 9N including a donor, an active layer 9K, and a second type (p-type) semiconductor layer 9P including an acceptor in this order. The first type semiconductor layer 9N is formed with a first contact layer 9A, a first cladding layer 9B, and a first optical guide layer 9C in this order. The second type semiconductor layer 9P is formed with an electron blocking layer 9D, a second optical guide layer 9E, a second cladding layer 9F, and a second contact layer 9G in this order, and the first electrode E1 (anode) is formed on the second contact layer 9G.

The second electrode E2 is provided on the same side as the first electrode E1 with respect to the base semiconductor part 8. The second electrode E2 is in contact with the first contact layer 9A, and the first and second electrodes E1 and E2 do not need to overlap each other in plan view. Specifically, part of the compound semiconductor part 9 may be dug down to the first contact layer 9A, and the second electrode E2 may be formed in a manner to be in contact with the first contact layer 9A exposed at a dug part 9Q of the compound semiconductor part 9. For example, the first electrode E1 is positioned on a (0001) plane of the second type semiconductor layer 9P (second contact layer 9G), and the second electrode E2 is positioned on the (0001) plane of the first type semiconductor layer 9N (first contact layer 9A). Note that although a region of the first contact layer 9A being in contact with the second electrode E2 has the same thickness as those of the other regions in Example 1, the region of the first contact layer 9A being in contact with the second electrode E2 may have a smaller thickness than those of the other regions. For example, part of the first contact layer 9A may be dug down to form a thin film part in the first contact layer 9A, the thin film part having a smaller thickness than that of the surrounding part, and then, the second electrode E2 (cathode) may be provided in a manner to be in contact with the thin film part. An upper surface (contact surface with the second electrode E2) of the thin film part may be, for example, the (0001) plane of the first contact layer 9A that is a nitride semiconductor layer.

In digging the compound semiconductor part 9 down by etching or the like, when the c-plane ((0001) plane) of the first contact layer 9A (for example, an n-GaN layer) is exposed and the second electrode E2 (cathode) is brought into contact with the c-plane of the first contact layer 9A, a contact resistance can be reduced (as compared with a contact resistance when the second electrode E2 is brought into contact with a -c-plane). The c-plane is a gallium polar plane, and the -c-plane is a nitrogen polar plane.

In plan view, the first electrode E1 and the second electrode E2 are aligned in the X direction (first direction). The first and second electrodes E1 and E2 each have a shape having the Y direction (second direction) as a longitudinal direction. A size WC of the second electrode E2 in the X direction may be smaller than a size W3 of the third part B3 in the X direction. The size WC of the second electrode E2 in the X direction may be larger than a size of the first electrode E1 in the X direction.

As illustrated in FIG. 7, the first electrode E1 may include a first region L1 being in contact with ridge part RJ, and the entire first region L1 may overlap the second part B2 (low-defect part) of the base semiconductor part 8 in plan view. A size WR of the first region L1 in the X direction may be smaller than a size W2 of the second part B2 in the X direction.

The compound semiconductor part 9 includes an optical resonator LK including a pair of resonant end surfaces F1 and F2. A resonant length (resonator length) K1 that is a distance between the pair of resonant end surfaces F1 and F2 is equal to or less than 200 [µm]. The resonant length K1 may be equal to or more than 20 [µm] and equal to or less than 200 [µm]. Each of the resonant end surfaces F1 and F2 is an m-plane of the compound semiconductor part 9, and is included in a cleavage surface of the compound semiconductor part 9. That is, each of the resonant end surfaces F1 and F2 can be formed by m-plane cleavage of the compound semiconductor part 9 that is a nitride semiconductor layer (for example, a GaN-based semiconductor layer). At least one of the base semiconductor part 8 and the compound semiconductor part 9 may have a scribe mark (mark of a cleavage start point) for cleavage. Note that the resonant end surfaces F1 and F2 can be formed by etching.

Each of the resonant end surfaces F1 and F2 is covered with a reflector film UF (for example, a dielectric film), and an optical reflectance of the resonant end surface F1 on a light emission surface side is, for example, equal to or more than 50%. An optical reflectance of the resonant end surface F2 on the light reflection surface side is larger than an optical reflectance of the resonant end surface F1. Although not illustrated in FIG. 5 and FIG. 7, the reflector film UF can be formed over the entire cleavage surface (m-plane) of the base semiconductor part 8 and the compound semiconductor part 9.

The first electrode E1 overlaps the optical resonator LK and overlaps the second part B2 of the base semiconductor part 8 in plan view. Lengths of the first and second electrodes E1 and E2 in the Y direction may be smaller than the resonant length K1. Thus, the first and second electrodes E1 and E2 do not interfere with the cleavage of the compound semiconductor part 9.

The optical resonator LK includes part of each of the first type semiconductor layer 9N, the active layer 9K, and the second type semiconductor layer 9P (each portion overlapping the first electrode E1 in plan view). For example, the optical resonator LK includes part of each of the first cladding layer 9B, the first optical guide layer 9C, the active layer 9K, the second optical guide layer 9E, and the second cladding layer 9F (each portion overlapping the first electrode E1 in plan view).

In the optical resonator LK, indices of refraction (indices of optical refraction) decrease in the order of the active layer 9K, the first optical guide layer 9C, and the first cladding layer 9B, and indices of refraction decrease in the order of the active layer 9K, the second optical guide layer 9E, and the second cladding layer 9F. Thus, light generated by combinations of holes supplied from the first electrode E1 and electrons supplied from the second electrode E2 in the active layer 9K is confined in the optical resonator LK (in particular, in the active layer 9K), and laser oscillation occurs due to stimulated emission and feedback action in the active layer 9K. The laser light generated by the laser oscillation is emitted from a light emission region EA of the resonant end surface F1 on the light emission surface side.

The resonant end surfaces F1 and F2, which are formed by the m-plane cleavage, have excellent flatness and perpendicularity to the c-plane (parallelism of the resonant end surfaces F1 and F2) and have a high optical reflectance. Thus, a mirror loss can be reduced, and stable laser oscillation can be performed even at a short resonant length being equal to or less than 200 µm that is a condition where reducing the mirror loss is difficult. The resonant end surfaces F1 and F2, which are formed on the second part B2 that is a low dislocation part, have excellent flatness of the cleavage surface and can achieve a high optical reflectance.

The compound semiconductor part 9 includes the ridge part (current constriction part) RJ overlapping the first electrode E1 in plan view. The ridge part RJ includes the second cladding layer 9F and part of the second optical guide layer 9E (part overlapping the first electrode E1 in plan view). An insulating film DF is provided on both sides of the ridge part RJ. An index of refraction of the insulating film DF may be smaller than the indices of refraction of the second optical guide layer 9E and the second cladding layer 9F. Providing the ridge part RJ and the insulating film DF constricts a current path between the first electrode E1 and the first type semiconductor layer 9N on the anode side, allowing light to be efficiently emitted in the resonator LK.

In plan view, the entire ridge part RJ overlaps the second part B2 (low dislocation part) of the base semiconductor part 8 (the ridge part RJ does not overlap the first part B1). With this configuration, the current path from the first electrode E1 to the first type semiconductor layer 9N through the active layer 9K is formed at the portion (low dislocation part) overlapping the second part B2 in the plan view, which enhances the light emission efficiency in the active layer 9K. This is because threading dislocation disturbs the movement of charges and causes a decrease in light emission efficiency.

In Example 1, a sum T1 of a thickness of the base semiconductor part 8 and a thickness of the compound semiconductor part 9 can be set to a value equal to or less than 50 [µm]. When the sum T1 of the thicknesses is too large, cleaving in a resonant length equal to or less than 200 µm becomes difficult.

The base semiconductor part 8 includes a base end surface (the cleavage surface of the base semiconductor part 8) that is the same plane as that of the resonant end surface F 1, and a density of dislocation (dislocation to be measured by a CL method on the cleavage surface, mainly basal plane dislocation) in the base end surface may be equal to or higher than a density of threading dislocation of the second part B2. A surface roughness of at least one of the pair of resonant end surfaces F1 and F2 (for example, the resonant end surface F2 on the reflection surface side) can be made smaller than a surface roughness of a side surface 9S (see FIG. 6) that is an a-plane of the compound semiconductor part 9. The a-plane is a (11-20) plane of the compound semiconductor part 9 that is a nitride semiconductor layer.

In Example 1, electrical power, for example, being equal to or less than 200 [mW] is supplied between the first and second electrodes E1 and E2, and a light-emitting body with low power consumption and low output can be achieved due to a short resonant length equal to or less than 200 µm. The configuration in which the first and second electrodes E1 and E2 are provided on one surface of the chip generally has disadvantages that the current path becomes long and the electrical resistance becomes large. However, when the configuration has the short resonant length (low output) as in Example 1, this point hardly causes a problem. An advantage can be also obtained that mounting (flip-chip mounting) on a submount or the like can be easily performed.

The lower surface (back surface) of the base semiconductor part 8 may include a region 8C having a locally large surface roughness (a rough surface region having a larger surface roughness than that of the surrounding region). At least one of a protruding part and a recessed part may be generated in the region 8C. For example, a plurality of raised parts having random shapes or a plurality of recessed parts having random shapes may be formed. The region 8C may be a region corresponding to the first part B1 (for example, a central region). The region 8C may be formed in a manner not to overlap the ridge part RJ in plan view. Using the region 8C may enhance heat dissipation. A dielectric film made of the same material as that of the reflector film UF may be formed in at least part of the region 8C.

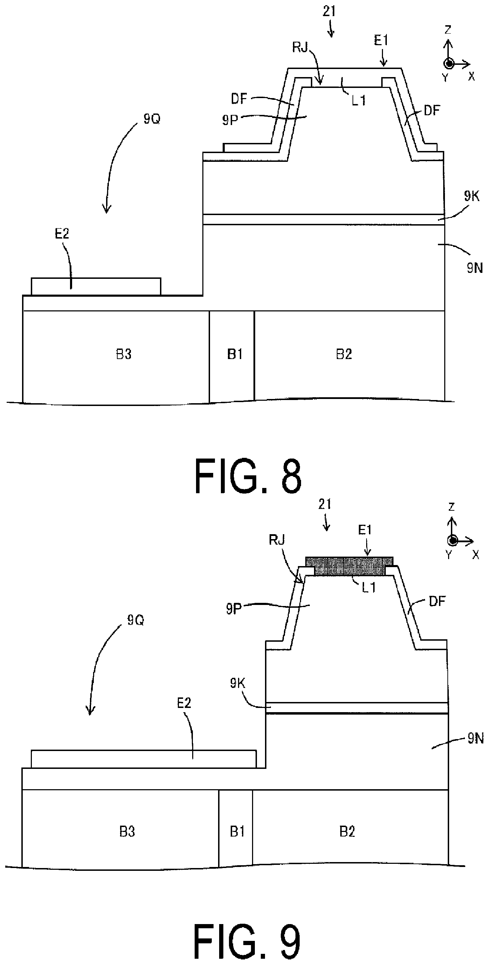

FIG. 8 is a cross-sectional view illustrating another configuration of the light-emitting body according to Example 1. As illustrated in FIG. 8, in the first electrode E1, a region other than the first region L1 may overlap the first part B1 in plan view. A region other than the first region L1 may also be positioned on the insulating film DF.

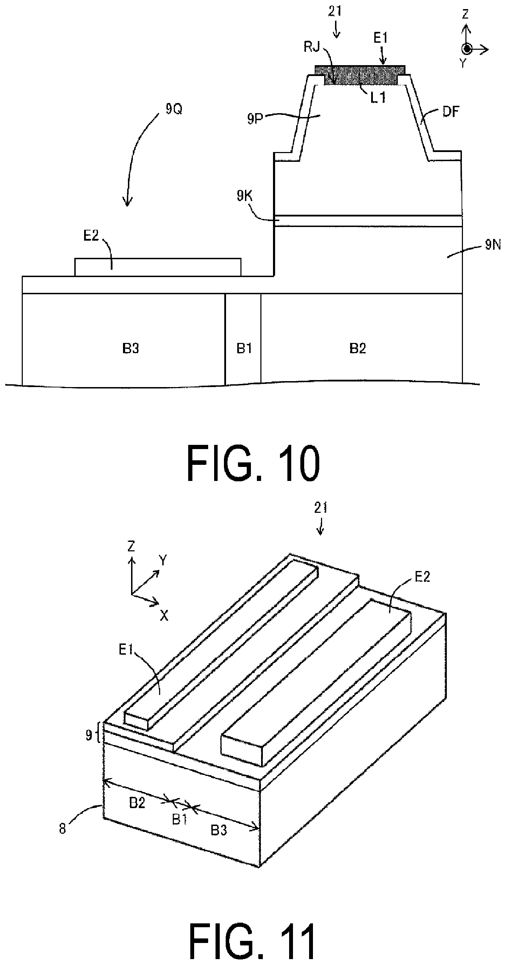

FIG. 9 to FIG. 10 are cross-sectional views illustrating other configurations of the light-emitting body according to Example 1. As illustrated in FIG. 9 and FIG. 10, the second electrode E2 positioned at the dug part 9Q of the compound semiconductor part may overlap the first part B1 of the base semiconductor part 8 in plan view.

FIG. 11 is a cross-sectional view illustrating another configuration of the light-emitting body according to Example 1. As illustrated in FIG. 11, a thickness of the second electrode E2 may be larger than a thickness of the first electrode E1, and the first electrode E1 and the second electrode E2 may have the same upper surface level. The first electrode E1 and the second electrode E2 may be made of different electrically conductive materials.

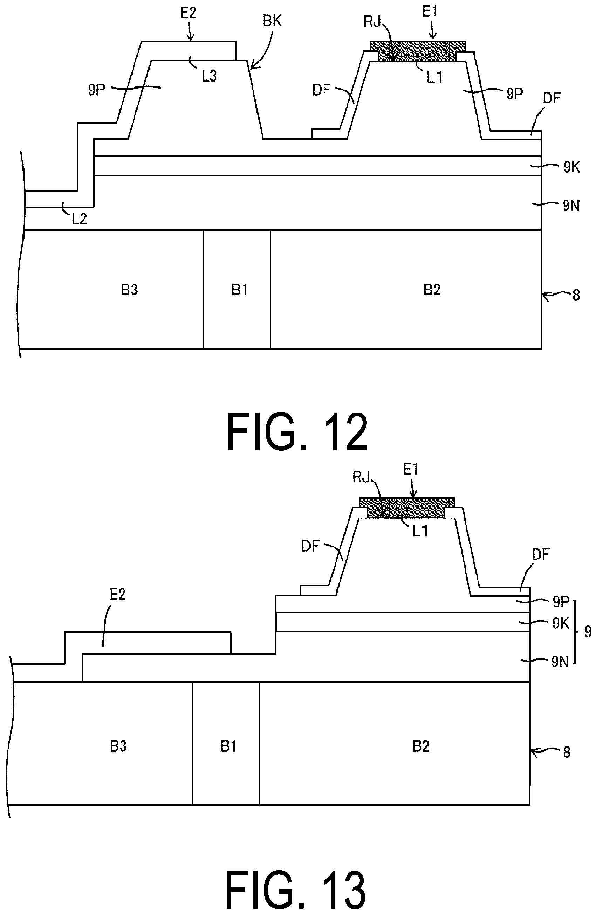

FIG. 12 is a cross-sectional view illustrating another configuration of the light-emitting body according to Example 1. As illustrated in FIG. 12, the compound semiconductor part 9 may include bank part BK, the ridge part RJ and the bank part BK may have the same upper surface level, and part of the second electrode E2 may be positioned on the bank part BK. The bank part BK may overlap the first part B1 of the base semiconductor part 8 in plan view. This facilitates mounting (flip-chip mounting) on a submount or the like. The ridge part RJ and the bank part BK may have the same structure (layer configuration).

As illustrated in FIG. 12, the second electrode E2 may include a second region L2 positioned on the first type semiconductor layer 9N and a third region L3 positioned on the second type semiconductor layer 9P. The third region L3 may overlap the first part B1 of the base semiconductor part 8 in plan view.

FIG. 13 is a cross-sectional view illustrating another configuration of the light-emitting body according to Example 1. As illustrated in FIG. 13, at least part of the second electrode E2 may be positioned on the compound semiconductor part 9, to be specific, on the first type (n-type) semiconductor layer 9N of the compound semiconductor part 9.

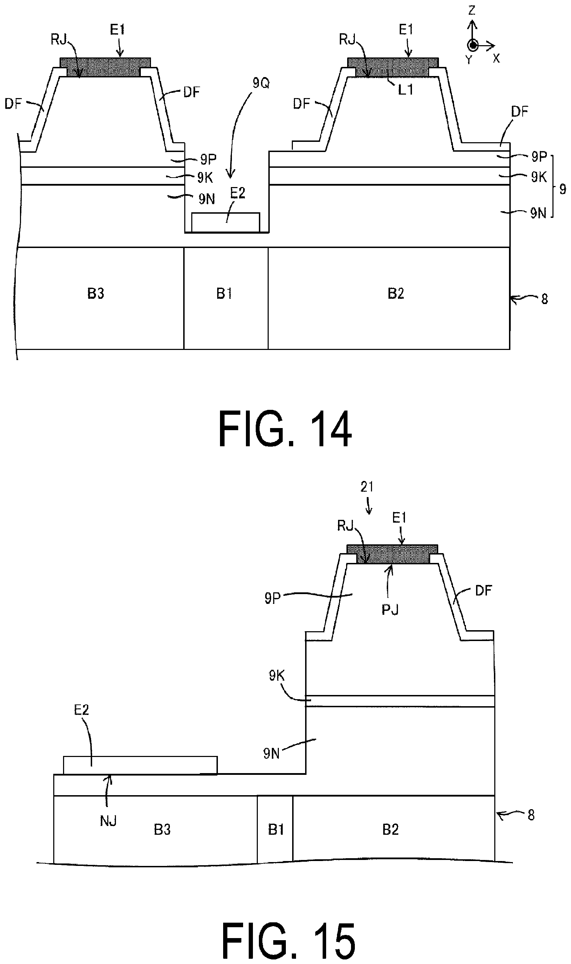

FIG. 14 is a cross-sectional view illustrating another configuration of the light-emitting body according to Example 1. As illustrated in FIG. 14, the entire second electrode E2 may overlap the first part B1 in plan view. The first type semiconductor layer 9N, the active layer 9K, the second type semiconductor layer 9P (including the ridge part RJ), and the first electrode E1 may be provided above each of the second part B2 and the third part B3 of the base semiconductor part 8. Providing the ridge parts in both the second part B2 and the third part B3 in this manner allows increasing the number of light-emitting bodies to be obtained, allows reducing a distance between light-emitting points of the light-emitting bodies when the light-emitting bodies are formed into one chip, increasing an integration density of light, and thus facilitating optical design, and allows taking a speckle noise countermeasure due to a difference between wavelengths of the light-emitting bodies.

FIG. 15 is a cross-sectional view illustrating another configuration of the light-emitting body according to Example 1. As illustrated in FIG. 15, the first electrode E1 may be positioned on a semipolar plane PJ of the second type semiconductor layer 9P, and the second electrode E2 may be positioned on a semipolar plane NJ of the first type semiconductor layer 9N. The semipolar plane is, for example, an r-plane inclined with respect to a c-plane that is a polar plane. Note that the first and second electrodes E1 and E2 may be provided on a nonpolar plane (a-plane or m-plane) perpendicular to the c-plane.

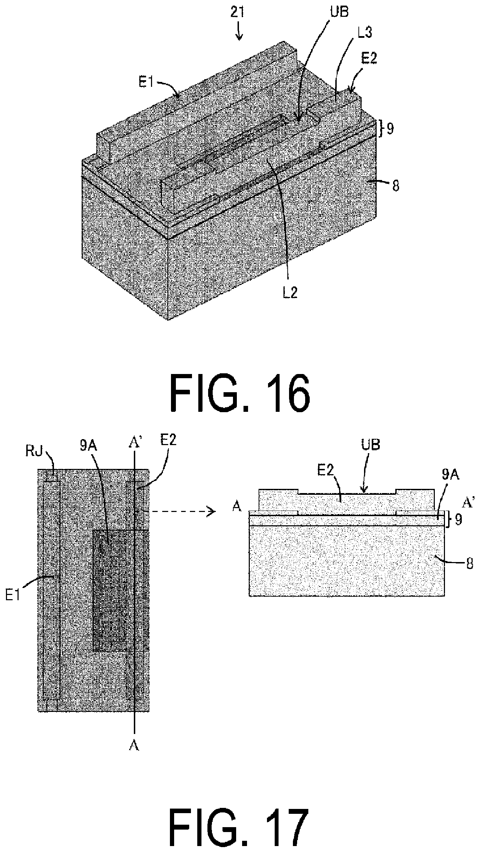

FIG. 16 is a perspective view illustrating another configuration of the light-emitting body according to Example 1. FIG. 17 is a top view and a cross-sectional view of FIG. 16. In the examples illustrated in FIG. 16 and FIG. 17, the second electrode E2 includes the second region L2 positioned on the first contact layer 9A and the third region L3 positioned on the second type semiconductor layer 9P. This configuration reduces a difference in the upper surface level between the first electrode E1 and the third region L3, and facilitates mounting. In this case, the second electrode E2 may include a recessed part UB on a surface thereof.

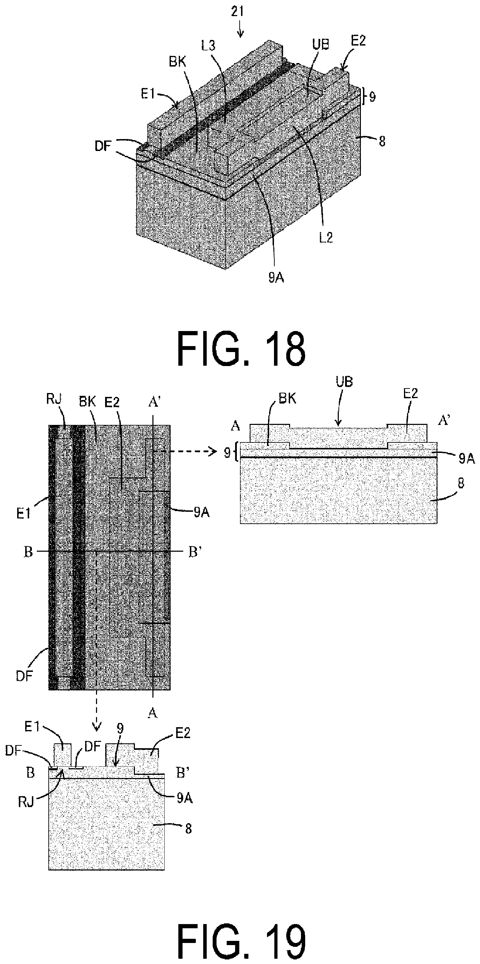

FIG. 18 is a perspective view illustrating another configuration of the light-emitting body according to Example 1. FIG. 19 is a top view and a cross-sectional view of FIG. 18. In the examples illustrated in FIG. 18 and FIG. 19, the compound semiconductor part 9 includes the bank part BK, the ridge part RJ and the bank part BK have the same upper surface level, and the second electrode E2 includes the second region L2 positioned on the first contact layer 9A and the third region L3 positioned on the bank BK. With this configuration, the upper surface levels of the first electrode E1 and the third region L3 coincide with each other, which facilitates mounting. In this case, the second electrode E2 includes the recessed part UB on a surface thereof.

FIG. 18 illustrates a case where when a ridge is formed, the second type (p-type) semiconductor layer is removed only in the vicinity of the sides of the ridge. The second electrode E2 is made larger than the first electrode E1, and in particular, an area of the third region L3 is made larger. As the area of the third region L3 is increased (a bonding surface area is increased), the third region L3 can be more firmly bonded to a support base, and handling in a subsequent step becomes easier. An insulating film (made of silicon oxide, silicon nitride, or the like) is present beside the ridge part RJ being in contact with the first electrode E1. However, since an adhesive force between metal and an insulating film is generally weak, the first electrode E1 may be peeled off at the position in peeling off from a growth substrate (which will be described later). Thus, increasing the area of the third region L3 (the second electrode E2 at a position where the insulating film is not present) is preferable to increasing the area of the first electrode E1. A shape of the first electrode E1 or the second electrode E2 may be a shape (for example, a shape including an alignment mark) that can be used for alignment (registration) at the time of bonding.

As for the third region L3, a contact resistance between the second electrode E2 as a cathode and the second type (p-type) semiconductor layer 9P is sufficiently high, thus a current does not flow, and both are not short-circuited.

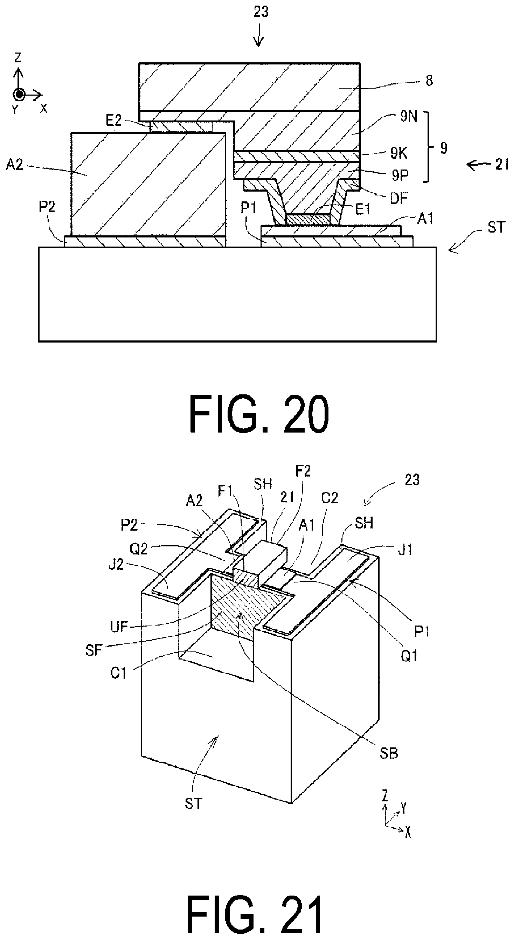

FIG. 20 is a cross-sectional view illustrating a configuration of a light-emitting element according to Example 1. The light-emitting element 23 includes the light-emitting body 21 including the base semiconductor part 8 and the compound semiconductor part 9, and the support body ST that holds the light-emitting body 21. Examples of a material to be used for the support body ST include Si, SiC, and AlN. The support body ST is disposed such that the compound semiconductor part 9 and the first and second electrodes E1 and E2 are positioned between the support body ST and the base semiconductor part 8. That is, the light-emitting body 21 is mounted on the support body ST into a junction-down type.

The support body ST includes a first pad P1 and a second pad P2 that have electrical conductivity. The first electrode E1 is connected to the first pad P1 via a first bonding part A1, and the second electrode E2 is connected to the second pad P2 via a second bonding part A2. A thickness of the second bonding part A2 is larger than a thickness of the first bonding part A1, and a difference between the thicknesses of the first and second bonding parts A1 and A2 is equal to or larger than a thickness of the compound semiconductor part 9. Thus, the first and second electrodes E1 and E2 can be connected to the first and second pads P1 and P2 positioned on the same plane, respectively. That is, the light-emitting element 23 functions as a chip on submount (COS).

FIG. 21 is a perspective view illustrating the configuration of the light-emitting element according to Example 1. As illustrated in FIG. 21, the light-emitting element 23 includes the light-emitting body 21 and the support body ST. The support body ST includes two wide parts SH each of which has a width larger than the resonant length of the light-emitting body 21 and a placement part SB positioned between the two wide parts SH and having a width smaller than the resonant length. The light-emitting body 21 is positioned above the placement part SB such that the width direction (Y direction) of the placement part SB coincides with a direction of the resonant length, and the pair of resonant end surfaces F1 and F2 protrude from the placement part SB in plan view. In other words, the placement part SB is formed between two notch parts C1 and C2 facing each other in the direction (Y direction) defining the resonant length, the resonant end surface F1 is positioned above the notch part C1, and the resonant end surface F2 is positioned above the notch part C2. Each of the notch parts C1 and C2 can be formed, for example, in a rectangular shape in plan view viewed in the Z direction.

The support body ST includes the first pad P1 and the second pad P2 each of which has a T-shape. The first pad P1 includes a mounting part J1 positioned on the wide part SH and having a length in the Y direction larger than the resonant length K1 and a contact part Q1 positioned on the placement part SB and having a length in the Y direction smaller than the resonant length K1. The second pad P2 includes a mounting part J2 positioned on the wide part SH and having a length in the Y direction larger than the resonant length K1, and a contact part Q2 positioned on the placement part SB and having a length in the Y direction smaller than the resonant length K1. The contact parts Q1 and Q2 are aligned in the X direction on the upper surface of the placement part SB, the first bonding part A1 is formed on the contact part Q1, and the second bonding part A2 is formed on the contact part Q2. The first bonding part A1 is in contact with the first electrode E1 of the light-emitting body 21, and the second bonding part A2 is in contact with the second electrode E2 of the light-emitting body 21. Solder such as AuSi or AuSn can be used as materials of the first and second bonding parts A1 and A2.

Although the resonant end surfaces F1 and F2 of the light-emitting body 21 are covered with the reflector film UF, a dielectric film SF made of the same material as that of the reflector film UF may be formed on a surface (for example, a side surface of the placement part SB) parallel to the resonant end surfaces F1 and F2 among side surfaces of the support body ST.

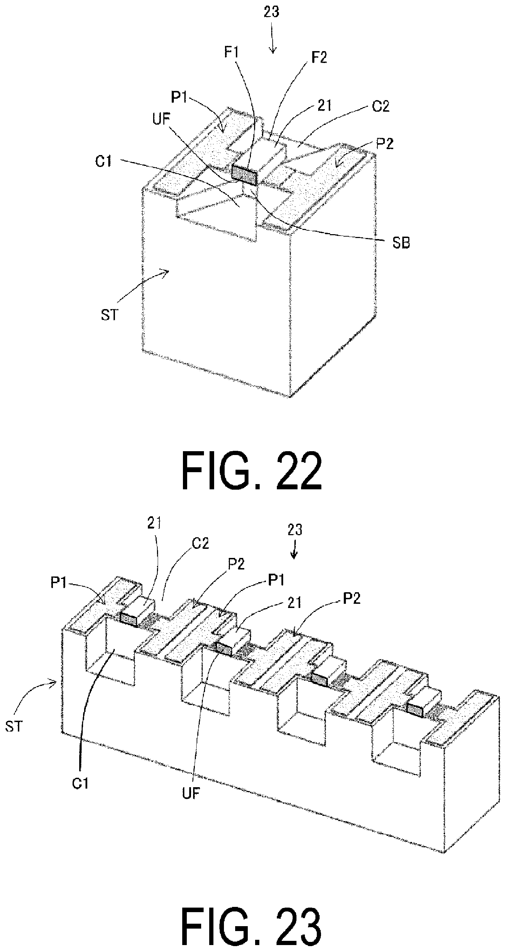

FIG. 22 is a cross-sectional view illustrating another configuration of the light-emitting element according to Example 1. In FIG. 21, each of the notch parts C1 and C2 has a rectangular shape in the plan view viewed in the Z direction, but the shape thereof is not limited thereto. As illustrated in FIG. 22, each of the notch parts C1 and C2 may be formed in a trapezoidal shape having a short side on the placement part SB side.

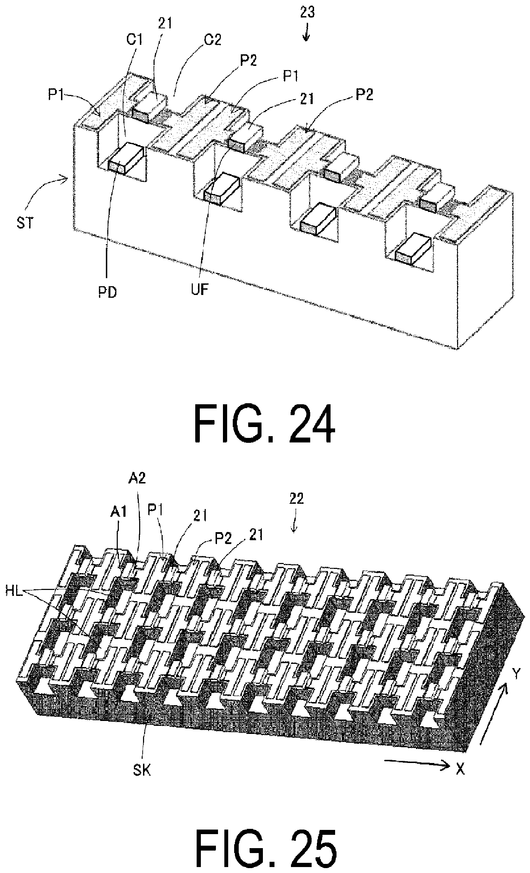

FIG. 23 and FIG. 24 are cross-sectional views illustrating other configurations of the light-emitting element according to Example 1. In the light-emitting element 23 of FIG. 23, a plurality of light-emitting bodies 21 may be aligned in a direction (the X direction) orthogonal to directions defining resonant lengths on the support body ST such that the directions of the resonant lengths thereof are aligned, and the first and second pads P1 and P2 may be provided corresponding to each of the light-emitting bodies 21. Note that as illustrated in FIG. 24, an optical device such as a photodiode PD may be provided in the notch part C1 of the support body ST. In this way, a light emission intensity of the light-emitting body 21 can be feedback-controlled.

FIG. 25 is a perspective view illustrating a configuration of a light-emitting substrate (semiconductor laser array) according to Example 1. A light-emitting substrate 22 includes the support substrate SK and a plurality of light-emitting bodies 21. In the light-emitting substrate 22, the plurality of light-emitting bodies 21 may be aligned in a matrix on the support substrate SK in a direction (the Y direction) defining resonant lengths and a direction (the X direction) orthogonal to the direction (the Y direction) such that the directions of the resonant lengths are aligned, and the first and second pads P1 and P2 and the first and second bonding parts A1 and A2 may be provided corresponding to each of the light-emitting bodies 21.

The support substrate SK can be formed by, for example, providing a plurality of recessed parts HL (each of which has a rectangular shape in plan view) in a matrix in a Si substrate, a SiC substrate, or the like and providing a plurality of first pads P1, a plurality of second pads P2, a plurality of first bonding parts A1, and a plurality of second bonding parts A2 in non-recessed parts.

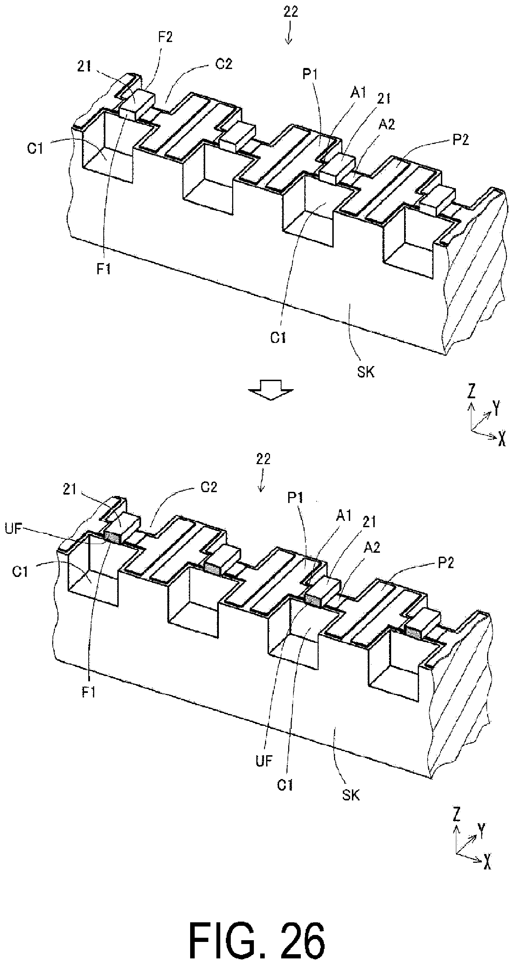

FIG. 26 is a perspective view illustrating another configuration of the light-emitting substrate according to Example 1. A light-emitting substrate of a two-dimensional arrangement type in which a plurality of light-emitting bodies 21 are aligned in a matrix as illustrated in FIG. 25 can also be laterally divided (divided for each row extending in the X direction) to form the light-emitting substrate 22 of a one-dimensional arrangement type (with a bar shape) as illustrated in FIG. 26. The one-dimensional arrangement type facilitates forming the reflector film UF on each of a pair of resonant end surfaces F1 and F2.

### Manufacturing Method

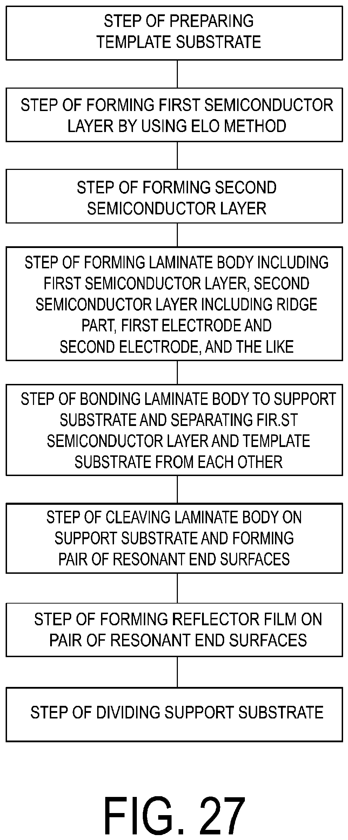

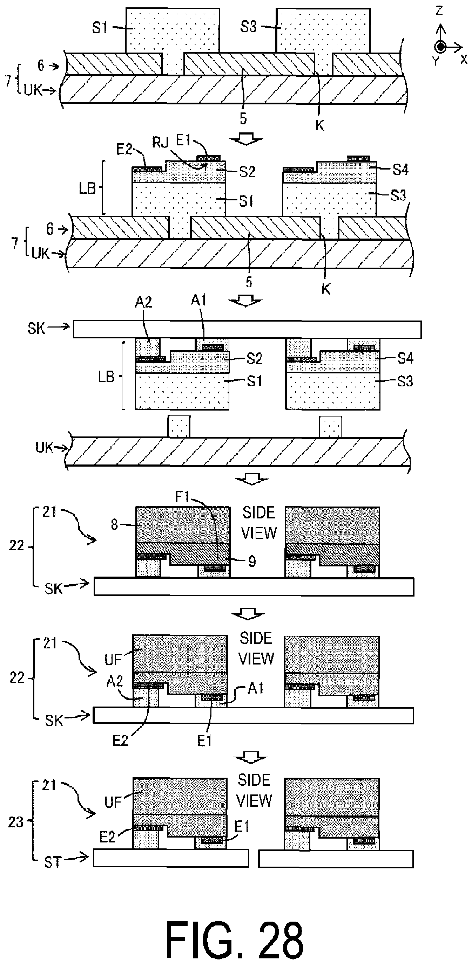

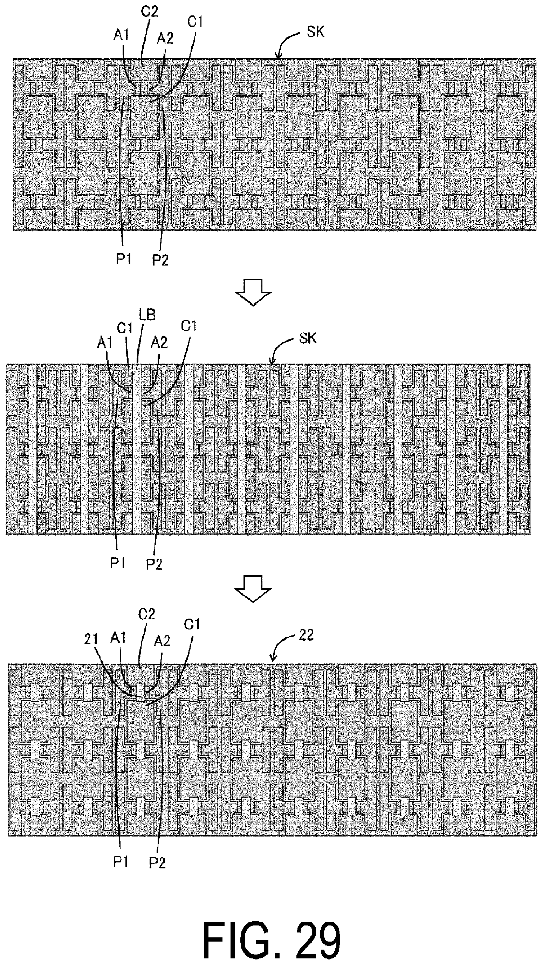

FIG. 27 is a flowchart illustrating an example of a method for manufacturing a light-emitting device according to Example 1. FIG. 28 is schematic cross-sectional views illustrating the method for manufacturing the light-emitting device in FIG. 27. FIG. 29 is plan views illustrating the method for manufacturing the light-emitting device in FIG. 27. The manufacturing method illustrated in FIG. 27 to FIG. 29 includes a step of preparing a template substrate 7 including a base substrate UK and the mask layer 6, a step of forming, by an ELO method, a first semiconductor layer S1 (and a third semiconductor layer S3) from which the base semiconductor part 8 is formed, which will be described later, a step of forming a second semiconductor layer S2 (and a fourth semiconductor layer S4) from which the compound semiconductor part 9 is formed, a step of forming a laminate body LB including the first semiconductor layer S1, the second semiconductor layer S2 including ridge part, the first electrode E1 and the second electrode E2, and the like, a step of bonding the laminate body LB to the support substrate SK and separating the first semiconductor layer S1 and the template substrate 7 from each other, a step of cleaving the laminate body LB on the support substrate SK and forming (the optical resonator LK including) a pair of resonant end surfaces F1 and F2, a step of forming the reflector film UF on each of the pair of resonant end surfaces F1 and F2, and a step of dividing the support substrate SK into a plurality of support bodies ST.

The mask layer 6 is removed by etching after forming the laminate body LB, and the laminate body LB is bonded to the support substrate SK after heating and melting the first and second bonding parts A1 and A2 (for example, solder) of the support substrate SK. Thus, a connection part (downward protruding part) of the back surface of the first semiconductor layer S1 with the base substrate UK is broken, and the first semiconductor layer S1 is separated from the template substrate 7. Then, the laminate body LB is cleaved (m-plane cleavage of the first and second semiconductor layers S1 and S2 that are nitride semiconductor layers) on the support substrate SK to form the pair of resonant end surfaces F1 and F2. Thus, the light-emitting substrate 22 (see FIG. 25) of a two-dimensional arrangement type is formed. Next, the light-emitting substrate of the two-dimensional arrangement type is divided for each row to form the light-emitting substrate 22 of a one-dimensional arrangement type (with a rod shape) (see FIG. 26). Next, the reflector film UF is formed on each of the resonant end surfaces F1 and F2 of the light-emitting substrate 22 of the one-dimensional arrangement type. Thereafter, the support substrate SK is divided into a plurality of support bodies ST, and each support body ST holds one or more light-emitting bodies 21, resulting in forming a plurality of light-emitting elements 23. The reflector film UF (for example, a dielectric film) may be formed not only on the cleavage surface (m-plane) of the base semiconductor part 8 and the compound semiconductor part 9 but also on surfaces (including the side surface of the placement part SB) parallel to the resonant end surfaces F1 and F2 among the side surfaces of the support body ST.

FIG. 30 and FIG. 31 are schematic cross-sectional views illustrating another example of the method for manufacturing the light-emitting device according to Example 1. As illustrated in FIG. 30, a plurality of light-emitting substrates 22 of the one-dimensional arrangement type (see FIG. 26) can be overlapped in the Z direction such that the back surfaces of the base semiconductor parts 8 face each other, and the reflector films UF can be simultaneously formed on the resonant end surfaces F1 and F2 of each of the light-emitting substrates 22. As illustrated in FIG. 31, when the support substrate SK is divided into a plurality of support bodies ST, each support body ST holds a plurality of light-emitting bodies 21, which also allows the light-emitting element 23 illustrated in FIG. 23 and the like to be formed.

### Base Semiconductor Part

FIG. 32 is cross-sectional views illustrating an example of growth of the base semiconductor part (ELO semiconductor layer) in a lateral direction in Example 1. As illustrated in FIG. 32, the base substrate UK includes a main substrate 1 and a base layer 4 on the main substrate 1, and a seed layer 3 as a surface layer of the base layer 4 is exposed from an opening part K of a mask part 5. First, by using the ELO method, an initial growth layer SL is formed on the seed layer 3, and then, the first semiconductor layer S1 can be laterally grown from an initial growth layer SL. The initial growth layer SL serves as a start point of growth of the first semiconductor layer S1 in the lateral direction and is part of the first part B1 of the base semiconductor part 8. The first semiconductor layer S1 may be controlled to grow in the Z direction (c-axis direction) or in the X direction (a-axis direction) by appropriately controlling ELO film formation conditions.

Here, the film formation of the initial growth layer SL can be stopped at a timing immediately before an edge of the initial growth layer SL rides on the upper surface of the mask part 5 (at a stage of being in contact with an upper end of a side surface of the mask part 5) or immediately after the edge of the initial growth layer SL rides on the upper surface of the mask part 5 (that is, at this timing, the ELO film formation condition is switched from the c-axis direction film formation condition to the a-axis direction film formation condition). With this, the film formation in the lateral direction is performed with the initial growth layer SL slightly protruding from the mask part 5, which reduces consumption of a material for growth of the first semiconductor layer S1 in a thickness direction, and allows the first semiconductor layer S1 to grow in the lateral direction at a high speed. The initial growth layer SL may be formed to have a thickness, for example, equal to or more than 2.0 µm and equal to or less than 3.0 µm.

In Example 1, an n-type GaN layer is used as the first semiconductor layer S1 from which the base semiconductor part 8 is formed, and an ELO film of Si-doped GaN (gallium nitride) is formed on the template substrate 7 by using an MOCVD apparatus. The following can be adopted as examples of the ELO film formation conditions: substrate temperature: 1120°C, growth pressure: 50 kPa, trimethylgallium (TMG): 22 sccm, NH₃: 15 slm, and V/III = 6000 (ratio of group V raw material supply amount to group III raw material supply amount). Before the first and third semiconductor layers S1 and S3 laterally growing from both sides of the mask part 5 meet each other on the mask part 5, the growth thereof in the lateral direction is stopped.

A width of the mask part 5 is 50 µm, a width of the opening part K is 5 µm, a lateral width of the first semiconductor layer S1 is 53 µm, a width (size in the X direction) of each of the low-defect parts B2 and B3 is 24 µm, and a layer thickness of the first semiconductor layer S1 is 5 µm. An aspect ratio of the first semiconductor layer S1 is 53 µm/5 µm = 10.6, and a very high aspect ratio can be achieved.

A different type of substrate having a different lattice constant from that of a nitride semiconductor can be used for the main substrate 1 in FIG. 32. Examples of the different kind of substrate include a single crystal silicon (Si) substrate, a sapphire (Al₂O₃) substrate, and a silicon carbide (SiC) substrate. The plane orientation of the main substrate 1 is, for example, the (111) plane of the silicon substrate, the (0001) plane of the sapphire substrate, or the 6H-SiC (0001) plane of the SiC substrate.

As the base layer 4 in FIG. 32, a buffer layer 2 and the seed layer 3 can be provided in order from the main substrate 1 side. For example, when a silicon substrate is used for the main substrate 1, and a GaN-based semiconductor is used for the seed layer 3, the main substrate and the seed layer melt together. Thus, for example, providing the buffer layer 2 including at least one of an AlN layer and a silicon carbide (SiC) layer can reduce such melting. The buffer layer 2 may have at least one of the effect of enhancing crystallinity of the seed layer 3 and the effect of relaxing an internal stress of the first semiconductor layer S1. When the main substrate 1 that is unlikely to melt together with the seed layer 3 is used, a configuration of not providing the buffer layer 2 may be adopted. Note that the present invention is not limited to the configuration in which the seed layer 3 overlaps the entire mask part 5 as illustrated in FIG. 32. Since the seed layer 3 only needs to be exposed from the opening part K, the seed layer 3 may be locally formed so as not to overlap part or the whole of the mask part 5.

The opening part K of the mask layer 6 has a function of a hole for starting growth. The hole exposes the seed layer 3 and starts growth of the first semiconductor layer S1. The mask part 5 of the mask layer 6 has a function of a mask for selective growth. The mask causes the first semiconductor layer S1 to grow in the lateral direction. The mask layer 6 may be a mask pattern including the mask part 5 and the opening part K.

As the mask layer 6, for example, a single layer film including at least one selected from the group consisting of a silicon oxide film (SiOx), a titanium nitride film (TiN or the like), a silicon nitride film (SiNx), a silicon oxynitride film (SiON), and a metal film having a high melting point (for example, equal to or higher than 1000°C), or a layered film including at least two selected from the group can be used.

For example, a silicon oxide film having a thickness of from about 100 nm to about 4 µm (preferably from about 150 nm to about 2 µm) is formed on the entire surface of the base layer 4 by using sputtering, and a resist is applied onto the entire surface of the silicon oxide film. Thereafter, the resist is patterned by photolithography to form the resist having a plurality of stripe-shaped opening parts. Thereafter, part of the silicon oxide film is removed by using a wet etchant such as hydrofluoric acid (HF), buffered hydrofluoric acid (BHF), or the like to form a plurality of opening parts K, and the resist is removed by organic cleaning to form the mask layer 6.

The opening parts K each have a longitudinal shape (slit shape) and are periodically aligned in the a-axis direction (X direction) of the first semiconductor layer S1. A width of the opening part K is from about 0.1 µm to about 20 µm. As the width of each opening part is smaller, the number of threading dislocations propagating from each opening part to the first semiconductor layer S1 decreases. Widths (sizes in the X direction) of the low-defect parts B2 and B3 can be increased.

The silicon oxide film is decomposed and evaporated in a small amount during the formation of the ELO semiconductor layer, and may be taken into the ELO semiconductor layer, but the silicon nitride film and the silicon oxynitride film have an advantage in terms of hardly decomposing and evaporating at a high temperature.

The mask layer 6 may be constituted by a single layer film of a silicon nitride film or a silicon oxynitride film, a layered film in which a silicon oxide film and a silicon nitride film are formed in this order on the base layer 4, a laminate body film in which a silicon nitride film and a silicon oxide film are formed in this order on the base layer 4, or a layered film in which a silicon nitride film, a silicon oxide film, and a silicon nitride film are formed in this order on the base layer.

When the base semiconductor part 8 is formed by using the ELO method, the template substrate 7 including the main substrate 1 and the mask layer 6 (mask pattern) on the main substrate 1 may be used. The template substrate 7 may include a growth suppression region (for example, a region that suppresses crystal growth in the Z direction) corresponding to the mask part 5 and a seed region corresponding to the opening part K. For example, a growth suppression region and a seed region can also be formed on the main substrate 1 to form the base semiconductor part 8 on the growth suppression region and the seed region by using the ELO method.

### Compound Semiconductor Part and Others

The compound semiconductor part 9 can be formed by using, for example, an MOCVD apparatus. For the first contact layer 9A, for example, an n-type GaN layer can be used, for the first cladding layer 9B, for example, an n-type AlGaN layer can be used, for the first optical guide layer 9C, for example, an n-type GaN layer can be used, for the active layer 9K, for example, a multi-quantum well (MQW) structure including an InGaN layer can be used, for an electron blocking layer 9D, for example, a p-type AlGaN layer can be used, for the second optical guide layer 9E, for example, a p-type GaN layer can be used, for the second cladding layer 9F, for example, a p-type AlGaN layer can be used, and for the second contact layer 9G, for example, a p-type GaN layer can be used.

The thicknesses of the respective layers of the light-emitting body 21 can be set as follows: the base semiconductor part 8 > the first cladding layer 9B > the first optical guide layer 9C > the active layer 9K, and the base semiconductor part 8 > the second cladding layer 9F > the second optical guide layer 9E > the active layer 9K. The indices of refraction of the respective layers of the compound semiconductor part 9 (the indices of refraction of light generated in the active layer 9K) can be set as follows: the first cladding layer 9B < the first optical guide layer 9C < the active layer 9K, and the insulating film DF < the second cladding layer 9F < the second optical guide layer 9E < the active layer 9K.

For the first and second electrodes E1 and E2 and the first and second pads P1 and P2, for example, a single layer film or a multilayer film including at least one of a metal film (which may be an alloy film) containing at least one selected from the group consisting of Ni, Rh, Pd, Cr, Au, W, Pt, Ti, and Al and an electrically conductive oxide film containing at least one selected from the group consisting of Zn, In, and Sn can be used. For the insulating film DF covering the ridge part RJ, for example, a single layer film or a layered film containing an oxide or a nitride of Si, Al, Zr, Ti, Nb, or Ta can be used.

The first semiconductor layer S 1 (ELO semiconductor layer) from which the base semiconductor part 8 is formed and the second semiconductor layer S2 from which the compound semiconductor part 9 is formed can be continuously film-formed by using the same film forming apparatus (for example, an MOCVD apparatus). An intermediate substrate on which the first semiconductor layer S 1 is film-formed can be temporarily removed from the film forming apparatus to film-form the second semiconductor layer S2 on the first semiconductor layer S 1 by using another apparatus. In this case, an n-type GaN layer (for example, having a thickness from about 0.1 µm to about 3 µm) serving as a buffer during regrowth may be formed on the first semiconductor layer S 1, and then, the second semiconductor layer S2 may be formed.

Examples of a material of the reflector film UF covering each of the resonant end surfaces F1 and F2 include dielectrics such as SiO₂, Al₂O₃, AlN, AlON, Nb₂O₅, Ta₂O₅, and ZrO₂. The reflector film UF may be a multilayer film. The reflector film UF can be formed by electron beam vapor deposition, electron cyclotron resonance sputtering, chemical vapor deposition, or the like.

In Example 1, a silicon substrate can be used for each of the main substrate 1, and the support substrate SK and the support body ST to be used for ELO of the base semiconductor part 8. In this case, bonding failure due to a difference in thermal expansion coefficient is less likely to occur at the time of bonding, and the method has advantages in large diameter, heat dissipation, workability, and cost.

The light-emitting body 21 has a structure in which the first and second electrodes E1 and E2 are provided only on a single side thereof (single-sided electrode structure), each of a surface of the first type semiconductor layer 9N connected to the second type electrode E2 and a surface of the second type semiconductor layer 9P connected to the first electrode E1 can be the (0001) plane (c-plane) of a GaN-based semiconductor. In the GaN-based semiconductor laser, when a substrate for crystal growth (for example, a GaN substrate) has electrical conductivity, typically, a semiconductor layer is formed such that a surface is a (0001) plane, and a double-sided electrode structure having a contact surface of an anode as a (0001) plane and a contact surface of a cathode as a back surface of the substrate for crystal growth, that is, a (000-1) plane is adopted. Adopting the single-sided electrode structure will cause a current to flow in a lateral direction between the anode and the cathode. This may make the current to non-uniformly flow in the ridge part (ridge waveguide), increasing a threshold current or making a current path longer than that with the double-sided electrode structure to increase a drive voltage. Thus, the single-sided electrode structure of the GaN-based semiconductor laser has been conventionally used only when the substrate for crystal growth has an insulating property and an electrode cannot be formed on the back surface side (for example, a sapphire substrate). When the (000-1) plane is used as a connection surface of the cathode, the fact that a contact resistance is high compared with that when the (0001) plane is used as the connection surface of the cathode is known, and thus a step of processing the (000-1) plane of the substrate for crystal growth by etching or the like to expose various planes is added.

In Example 1, even when the double-sided electrode structure can be employed, such as when the substrate for crystal growth (main substrate) has electrical conductivity or when the main substrate is removed and the base semiconductor part having electrical conductivity is positioned on the back surface side, an advantage of adopting the single-sided electrode structure can also be obtained. Not only is a drive current originally small at a short resonant length, but also driving is performed near a threshold current in an application of augmented reality (AR) glasses for which a high optical output or the like is not required. Thus, an increase in series resistance that causes an increase in voltage according to a current value does not cause a big problem. On the other hand, when the (0001) plane is used as the connection surface of the cathode, an advantage that the contact resistance is reduced (power consumption is reduced) is obtained, and further, mounting on a submount (the support substrate SK or the like) is also facilitated.

### Example 2

FIG. 33 is a cross-sectional view illustrating a configuration of a light-emitting body according to Example 2. The light-emitting body 21 includes the base semiconductor part 8, the compound semiconductor part 9 positioned on the base semiconductor part 8, the first electrode E1 as an anode, and the second electrode E2 as a cathode. The light-emitting body 21 can also be referred to as a light-emitting diode (LED) chip. The compound semiconductor part 9 is formed with the first type (n-type) semiconductor layer 9N including a donor, the active layer 9K, and the second type (p-type) semiconductor layer 9P including an acceptor in this order. At least part of the first electrode E1 is positioned on the (0001) plane of the second type semiconductor layer 9P, and at least part of the second electrode E2 is positioned on the (0001) plane of the first type semiconductor layer 9N.

In plan view, the entire first electrode E1 overlaps the second part B2 (low dislocation part) of the base semiconductor part 8 (the first electrode E1 does not overlap the first part B1). With this configuration, the current path from the first electrode E1 to the first type semiconductor layer 9N through the active layer 9K is formed at the portion (low dislocation part) overlapping the second part B2 in the plan view, which enhances the light emission efficiency in the active layer 9K.

### Example 3

In Examples 1 and 2, the GaN layer can be used for the base semiconductor part 8 (ELO semiconductor layer), but the configuration is not limited thereto. As the ELO semiconductor layer, an InGaN layer that is a GaN-based semiconductor layer can also be formed. The film formation in the lateral direction of the InGaN layer is performed at a low temperature below 1000°C, for example. This is because a vapor pressure of indium increases at a high temperature and indium is not effectively taken into the film. When the film formation temperature is low, an effect is exhibited in which an interaction between the mask part 5 and the InGaN layer is reduced. The InGaN layer has an effect of exhibiting lower reactivity with the mask part 5 than that of the GaN layer. When indium is taken into the InGaN layer at an In composition level equal to or more than 1%, the reactivity with the mask part 5 is further lowered. As a gallium raw material gas, triethylgallium (TEG) can be used.

### Example 4

FIG. 34 is a perspective view illustrating a configuration of a light-emitting module according to Example 4. A light-emitting module 24 (light-emitting device) in FIG. 34 is a surface mount type package, and includes a casing 35 and the light-emitting element 23 (see, for example, FIG. 23). The light-emitting element 23 includes a plurality of light-emitting bodies 21, and is provided such that a side surface (a surface parallel to the resonant end surface) of the support body ST faces a bottom surface 37 of the casing 35. Thus, the light emission surface (the resonant end surface on the light emission side) of each light-emitting body 21 faces a top surface 34 (a transparent plate) of the casing 35, and laser light is emitted from the top surface 34 of the casing 35. The light-emitting element 23 is connected to an external connection pin 33 through a wiring line 31.

FIG. 35 is a perspective view illustrating another configuration of the light-emitting module according to Example 4. The light-emitting module 24 in FIG. 35 is a TO-CAN mount type package, and includes a stem 38 and the light-emitting element 23 (for example, see FIG. 21). The light-emitting element 23 is disposed on a heat block 36 protruding from a base of the stem 38. Each of the first and second pads P1 and P2 of the light-emitting element 23 is connected to the external connection pin 33 through the wiring line 31.

In the related art, a chip on submount (CoS) needs to be manufactured by individually die-bonding a semiconductor laser chip to a submount. However, in Examples 1 to 4, since the support body ST of the light-emitting element 23 functions as a submount and the light-emitting element 23 itself has a CoS structure, die-bonding to a submount is not necessary. This makes it possible to solve a problem of difficulty in handling when the resonant length is short or the chip width is narrow. To be more specific, the light-emitting element 23 includes the first and second pads P1 and P2 that satisfy size conditions required for wire bonding on the support body ST. Since the first and second pads P1 and P2 are electrically connected to the first and second electrodes (anode and cathode) of the light-emitting body 21 (semiconductor laser chip), electrically connecting the external connection pins 33 of the package and the first and second pads P1 and P2 through the wiring lines 31 is only required.

### Example 5

FIG. 36 is a schematic view illustrating a configuration of an electronic device according to Example 5. An electronic device 50 in FIG. 36 includes the light-emitting device GD (21 to 24) described in Examples 1 to 4 and a controller 80 that includes a processor and that controls the light-emitting device GD. Examples of the electronic device 50 include a lighting device, a display device, a communication device, an information processing device, a medical device, an electric vehicle (EV), and the like.

The above technical formations have been presented for purposes of illustration and description, and not limitation. Based on these illustration and description, a person skilled in the art will obviously appreciate that many variations can be made.

### Supplementary Note

In the present disclosure, the invention has been described above based on the various drawings and examples. However, the invention according to the present disclosure is not limited to each embodiment described above. That is, the embodiments of the invention according to the present disclosure can be modified in various ways within the scope illustrated in the present disclosure, and embodiments obtained by appropriately combining the technical means disclosed in different embodiments are also included in the technical scope of the invention according to the present disclosure. In other words, a person skilled in the art can easily make various variations or modifications based on the present disclosure. Note that these variations or modifications are included within the scope of the present disclosure.

### REFERENCE SIGNS

7 Template substrate
8 Base semiconductor part
9 Compound semiconductor part
21 Light-emitting body (light-emitting device)
22 Light-emitting substrate (light-emitting device)
23 Light-emitting element (light-emitting device)
24 Light-emitting module (light-emitting device)
S 1 First semiconductor layer
S2 Second semiconductor layer
LK Optical resonator
RJ Ridge part
B 1 First part
B2 Second part (low dislocation part)
B2 Third part (low dislocation part)
F1, F2 Pair of resonant end surfaces
P1 First pad
P2 Second pad
E1 First electrode
E1 Second electrode
UF Reflector film
ST Support body
SB Placement part
SK Support substrate

## Claims

1. A light-emitting body, comprising:
a base semiconductor part comprising a nitride semiconductor;
a compound semiconductor part comprising a nitride semiconductor and positioned above the base semiconductor part; and
a first electrode and a second electrode,
wherein the base semiconductor part comprises
first part and
second part having a density of threading dislocation extending in a thickness direction lower than that of the first part,
at least part of the first electrode and at least part of the second electrode are positioned on the compound semiconductor part, and
at least part of the first electrode is positioned above the second part.

2. The light-emitting body according to claim 1, wherein the density of threading dislocation of the second part is equal to or less than one fifth of the density of threading dislocation of the first part.

3. The light-emitting body according to claim 1 or 2,
wherein an <11-20> direction and a <1-100> direction of the nitride semiconductor included in the base semiconductor part are respectively referred as a first direction and a second direction, and
the first part and the second part are aligned in the first direction.

4. The light-emitting body according to any one of claims 1 to 3,
wherein the base semiconductor part comprises third part having a density of threading dislocation extending in the thickness direction lower than that of the first part, and
the first part is positioned between the second part and the third part.

5. The light-emitting body according to claim 4, wherein the second electrode and the third part overlap each other in plan view.

6. The light-emitting body according to any one of claims 1 to 5,
wherein an upper surface of the base semiconductor part is in contact with the compound semiconductor part, and
a lower surface of the base semiconductor part is exposed.

7. The light-emitting body according to any one of claims 1 to 6, wherein at least part of the first electrode and at least part of the second electrode are positioned on a (0001) plane of the compound semiconductor part.

8. The light-emitting body according to claim 3, wherein the first electrode and the second electrode are aligned in the first direction in plan view.

9. The light-emitting body according to claim 3, wherein the first electrode and the second electrode each have a shape having the second direction as a longitudinal direction.

10. The light-emitting body according to any one of claims 1 to 9,
wherein a thickness of the second electrode is larger than a thickness of the first electrode, and
the first electrode and the second electrode have an identical upper surface level.

11. The light-emitting body according to any one of claims 1 to 10, wherein the first electrode and the second electrode are made of different electrically conductive materials.

12. The light-emitting body according to any one of claims 1 to 6, wherein at least part of the first electrode and at least part of the second electrode are positioned on a semipolar plane of the compound semiconductor part.

13. The light-emitting body according to any one of claims 1 to 12, wherein the density of threading dislocation of the second part of the base semiconductor part is equal to or less than 5 × 10⁶/cm².

14. The light-emitting body according to any one of claims 1 to 13, wherein the first electrode is a cathode, and
the second electrode is an anode.

15. The light-emitting body according to claim 4 or 5,
wherein an <11-20> direction and a <1-100> direction of the nitride semiconductor included in the base semiconductor part are respectively referred as a first direction and a second direction, and
a size of the second electrode in the first direction is smaller than a size of the third part in the first direction.

16. The light-emitting body according to any one of claims 1 to 15, wherein a sum of a thickness of the base semiconductor part and a thickness of the compound semiconductor part is equal to or less than 50 [µm].

17. The light-emitting body according to any one of claims 1 to 16, wherein the compound semiconductor part comprises a first type semiconductor layer, an active layer, and a second type semiconductor layer in this order.

18. The light-emitting body according to any one of claims 1 to 17, wherein the compound semiconductor part comprises an optical resonator comprising a pair of resonant end surfaces.

19. The light-emitting body according to claim 18, wherein the compound semiconductor part comprises ridge part configured to constrict a current.

20. The light-emitting body according to claim 19, wherein an insulating film is positioned on both sides of the ridge part in plan view.

21. The light-emitting body according to claim 19 or 20,
wherein the first electrode comprises a first region in contact with the ridge part, and
an entirety of the first region overlaps the second part in plan view.

22. The light-emitting body according to claim 21,
wherein an <11-20> direction and a <1-100> direction of the nitride semiconductor included in the base semiconductor part are respectively referred as a first direction and a second direction, and
a size of the first region in the first direction is smaller than a size of the second part in the first direction.

23. The light-emitting body according to any one of claims 19 to 22,
wherein the compound semiconductor part comprises bank part, and
the ridge part and the bank part have an identical upper surface level,
a part of the second electrode is positioned on the bank part.

24. The light-emitting body according to claim 23, wherein the bank part overlaps the first part of the base semiconductor part in plan view.

25. The light-emitting body according to any one of claims 18 to 24, wherein a resonant length of the optical resonator is equal to or smaller than 200 [µm].

26. The light-emitting body according to any one of claims 18 to 25, wherein the base semiconductor part and the compound semiconductor part include a GaN-based semiconductor.

27. The light-emitting body according to claim 26, wherein an individual resonant end surface is an m-plane of the GaN-based semiconductor.

28. The light-emitting body according to claim 17,
wherein the first electrode is in contact with a (0001) plane of the second type semiconductor layer, and
the second electrode is in contact with a (0001) plane of the first type semiconductor layer.

29. The light-emitting body according to claim 28,
wherein the compound semiconductor part comprises a dug part by which a (0001) plane of the first type semiconductor layer is exposed, and
the second electrode is disposed in the dug part.

30. The light-emitting body according to claim 17, wherein the second electrode comprises a second region positioned on the first type semiconductor layer and a third region positioned on the second type semiconductor layer.

31. The light-emitting body according to claim 30, wherein the third region overlaps the first part in plan view.

32. The light-emitting body according to claim 17, wherein an entirety of the second electrode overlaps the first part in plan view.

33. A light-emitting element, comprising:
a light-emitting body described in claim 18; and
a support body supporting the light-emitting body.

34. The light-emitting element according to claim 33, wherein the support body comprises a base member, a first pad, and a second pad.

35. The light-emitting element according to claim 34, further comprising
a first electrically conductive bonding part and a second electrically conductive bonding part,
wherein the first electrode is connected to the first pad via the first electrically conductive bonding part, and
the second electrode is connected to the second pad via the second electrically conductive bonding part.

36. The light-emitting element according to claim 35, wherein the second electrically conductive bonding part is thicker than the first electrically conductive bonding part.

37. The light-emitting element according to any one of claims 34 to 36, wherein the base member contains silicon or silicon carbide.

38. The light-emitting element according to any one of claims 34 to 37,
wherein the support body comprises a placement part having a width smaller than a resonant length of the optical resonator, and
the light-emitting body is positioned on the placement part with a width direction of the placement part coinciding with a direction defining the resonant length.

39. The light-emitting element according to claim 38, wherein at least one of the pair of resonant end surfaces protrudes from the placement part in plan view.

40. The light-emitting element according to claim 39,
wherein the placement part is formed between two notch parts facing each other in the direction defining the resonant length, and
each of the pair of resonant end surfaces is positioned on a respective one of the two notch parts.

41. The light-emitting element according to any one of claims 34 to 40, wherein the first pad and the second pad each have a size in a direction defining a resonant length of the optical resonator larger than the resonant length.

42. The light-emitting element according to any one of claims 33 to 41, further comprising a reflector film covering at least one of the pair of resonant end surfaces.

43. A light-emitting element, comprising:
a base semiconductor part comprising a nitride semiconductor;
a compound semiconductor part positioned on a (0001) plane of the base semiconductor part and comprising a first type semiconductor layer comprising a nitride semiconductor and a second type semiconductor layer comprising a nitride semiconductor;
a first electrode at least part of which is positioned on a (0001) plane of the second type semiconductor layer;
a second electrode at least part of which is positioned on a (0001) plane of the first type semiconductor layer;
a first electrically conductive bonding part and a second electrically conductive bonding part; and
a support body comprising a first pad connected to the first electrode via the first electrically conductive bonding part, a second pad connected to the second electrode via the second electrically conductive bonding part, and a base member.

44. An electronic device, comprising:
a light-emitting body described in any one of claims 1 to 32.

45. A method for manufacturing a light-emitting body described in any one of claims 1 to 32, the method comprising
forming the base semiconductor part by using an ELO method.

46. The method for manufacturing the light-emitting body according to claim 45, further comprising:
forming the compound semiconductor part comprising a first type semiconductor layer, an active layer, and a second type semiconductor layer in this order; and
exposing a (0001) plane of the first type semiconductor layer by etching part of the compound semiconductor part.

47. The method for manufacturing a light-emitting element described in any one of claims 33 to 43, the method comprising:
forming the base semiconductor part of the light-emitting body by using an ELO method using a template substrate comprising a main substrate and a mask; and
flip-chip mounting the light-emitting body on a support substrate comprising the support body.

48. The method for manufacturing the light-emitting element according to claim 47, wherein a silicon substrate is used for each of the main substrate and the support substrate.

49. An apparatus for manufacturing a light-emitting body described in any one of claims 1 to 32, the apparatus comprising
a semiconductor former configured to form the base semiconductor part by using an ELO method.
